# EUROPEAN PATENT APPLICATION

(11) **EP 4 687 292 A1**
(43) Date of publication of application: **04.02.2026**
(21) Application number: 24191740.0
(22) Date of filing: 30.07.2024
(51) Int. Cl.: H03K 5/24, H03M 1/12

(54) **CONTINUOUS-TIME COMPARATOR CIRCUITRY**

(71) Applicant: Imec VZW, 3001 Leuven (BE)
(72) Inventor: LI, Hanyue, 3001 Leuven (BE); Craninckx, Jan, 3001 Leuven (BE); MARTENS, Ewout, 3001 Leuven (BE)
(74) Representative: Ipsilon Belgium

(57) **Abstract**

A continuous-time comparator circuitry (1, 5) for generating an output voltage signal (105) at an output node (15, 55) triggered by a difference between an input voltage signal (103) at an input node (13, 53) and a reference voltage signal (104) at a reference node (14, 54), the circuitry comprising: power supply nodes (11, 51, 12, 52); a current source sub-circuitry (170, 570); a feedback sub-circuitry (150, 550) configured to conduct a bias current between a second power supply node and a second intermediate node (121, 521); a first amplifier (130, 530) having as input the input node, as output the output node, and as voltage power supply first and second intermediate nodes; and a second amplifier (140, 540) having as input the reference node, as output a feedback node (16, 56), and as voltage power supply the first and second intermediate nodes; wherein the feedback node is fed back to the feedback sub-circuitry to provide a constant power supply voltage over the first and second amplifiers such that the triggering follows the reference voltage signal.

## Description

### Technical field

The present invention generally relates to a continuous-time comparator circuitry and an analogue-to-digital converter, ADC, circuitry comprising one or more continuous-time comparator circuitries.

### Background

A continuous-time voltage comparator circuitry compares two input voltage signals to generate a binary output voltage signal. The output signal depends on the polarity of the input signals. In other words, a value of the output signal depends on which of the input signals is largest. The output signal toggles as the input signals switch turns regarding which has the largest voltage amplitude.

A continuous-time comparator may be implemented by providing a differential input pair of transistors that share a common current source. As such, the comparator is a differential amplifier. The first transistor of the pair takes as input the first input voltage signal. The second transistor takes the second input voltage signal, which is typically a reference signal against which the first input signal is compared. The voltage output of one of these transistors then serves as output signal and will toggle when the input signal crosses a level of the reference signal.

The speed of such a comparator is determined by the gain-bandwidth product. The larger the gain-bandwidth product, the faster the toggling. The gain-bandwidth product may be increased by increasing the power consumption of the comparator. Alternatively, a comparator may be provided by providing two complementary differential pairs in parallel with two current sources, one provided at a higher voltage supply node and a second one at a lower voltage supply node. This would also require some form of common-mode feedback to ensure that the two current sources are the same. Such a comparator would have a bandwidth that is doubled.

During the design of a voltage comparator, the target delay or speed determines the gain-bandwidth product and, thus the dimensions and associated power consumption of the transistors and other circuitry components. The dimensioning must be done such that the target gain-bandwidth product is achieved within certain margins of operation variations. Such variations may, for example, be caused by variations of the voltage supply, of the ambient temperature, or by variations in manufacturing, i.e. variations within certain process-voltage-temperature, PVT, corners. Therefore, the power consumption of the resulting comparator will be determined by the worst PVT corner to ensure that the comparator performs under all foreseen operating conditions. As a result, known comparators as described above have a much higher gain-bandwidth product than needed under normal circumstances and thus have an unnecessary excess power consumption.

It is an object of the invention to provide a continuous-time comparator circuitry that alleviates one or more of the abovementioned obstacles.

### Summary

According to some aspects, there is provided the subject matter of the independent claims. Some further aspects are defined in the dependent claims.

According to a first aspect, a continuous-time comparator circuitry is provided for generating an output voltage signal at an output node triggered by a difference between an input voltage signal at an input node and a reference voltage signal at a reference node. The comparator circuitry comprises:
- a first voltage power supply node and a second voltage power supply node;
- a current source sub-circuitry configured to provide a bias current between the first power supply node and a first intermediate node;
- a feedback sub-circuitry configured to conduct the bias current between the second power supply node and a second intermediate node;
- a first amplifier having as input the input node, as output the output node, and as voltage power supply the first and second intermediate nodes thereby providing the output voltage signal with a voltage swing between the voltages at the first and second intermediate nodes; and
- a second amplifier having as input the reference node, as output a feedback node, and as voltage power supply the first and second intermediate nodes.
The feedback node is fed back to the feedback sub-circuitry such that voltages at the first and second intermediate node follow the reference voltage signal, thereby providing a constant power supply voltage over the first and second amplifiers such that the triggering follows the reference voltage signal.

The comparator circuitry compares the input voltage signal to the reference voltage signal, which is set as a threshold. Under normal operation, the reference voltage signal is a constant value, i.e. a direct current, DC, voltage. The reference voltage signal can be altered over time as the comparator needs to operate on a different threshold according to how it is used. The reference voltage signal may also fluctuate due to physical variations in the circuitry. The reference voltage signal may take a value around half, i.e. 50%, of the power supply, e.g. around 40% or around 60% of the power supply. Alternatively, the second input of the comparator, i.e. the reference voltage, can also be a varying input voltage. In any case, the reference voltage signal is limited to a range depending on an implementation of the comparator. For example, the range is determined by threshold voltages and dimensions of transistors, a value of the supply voltage, among others.

The first amplifier is configured to bring the voltage on the output node either to the first or to the second intermediate voltage signal, depending on the input voltage signal. As such, the first amplifier only draws current during toggling of the output voltage signal.

The current source sub-circuitry provides a fixed direct current, DC, bias to the comparator circuitry. Except during switching of the first amplifier, this current flows entirely through the second amplifier and the feedback sub-circuitry.

The feedback sub-circuitry has three nodes: a controlling node and two nodes configured to conduct current between them during operation. The current flowing through the current conducting nodes is controlled by a signal, e.g. a voltage signal, applied to the controlling node. The feedback node of the comparator coincides with the controlling node of the feedback sub-circuitry. The second intermediate node and the second voltage power supply node coincide with the current conducting nodes. Thus, the current flowing between the second intermediate node and the second voltage power supply node is controlled by the feedback voltage signal. In other words, the feedback sub-circuitry pushes the second intermediate voltage signal up and down depending on the feedback voltage signal. Because of the feedback and setting of the reference voltage signal around half of the voltage power supply, the second amplifier is configured to continuously draw current during normal operation of the comparator circuitry. In other words, the second amplifier is powered by the voltage over the two intermediate nodes such that it draws said current.

The first and second amplifiers are connected in parallel over the first and second intermediate nodes, which as such act as local voltage power supply nodes for the amplifiers.

The second amplifier outputs the feedback voltage signal depending on the reference voltage signal. As such, the reference voltage signal indirectly controls the second intermediate voltage signal. The second amplifier is configured to keep a constant voltage over its local power supply nodes, i.e. the first and second intermediate nodes. Therefore, the first intermediate voltage signal shifts according to the second intermediate voltage signal so as to maintain the constant voltage difference over the second amplifier. Thus, the voltages at the first and second intermediate nodes may shift up and down while maintaining a constant voltage difference. In other words, the voltages at the first and second intermediate nodes change in tandem in function of the reference voltage signal. Consequently, the second amplifier determines the voltage power supply over the first amplifier. As a result, the second amplifier causes the first amplifier to implement a threshold equal to the reference voltage signal during the determination of the output voltage signal.

Because of the fixed DC biasing, a very stable biasing is provided contrarily to self-biased comparators. In other words, current consumption spread or variation is reduced. The comparator is therefore much less influenced by variations during operation, e.g. within the process-voltage-temperature, PVT, corners. Therefore, a smaller delay can be achieved for the same predefined PVT corners. As a result, a lower power consumption can be achieved. In other words, the comparator has an increased power efficiency.

In addition, the comparator has the ability to vary the voltage over the first and second intermediate nodes proportionally to the reference voltage. For example, for a constant reference voltage, the voltage over the first and second intermediate nodes is constant as well. This allows keeping the power, speed and amplitude trigger point constant even if the reference voltage is not exactly equal to half of the supply voltage. In other words, a stable operation is achieved even when the reference voltage signal deviates from half of the supply voltage. Further, the comparator provides the same power consumption and speed for different values of the reference voltage signal. This further adds to the above-mentioned advantages.

According to further example embodiments, the feedback sub-circuitry comprises a feedback transistor provided between the second power supply node and the second intermediate node; and the feedback node is fed back to a gate of the feedback transistor.

The feedback transistor is a voltage-to-current transistor, such as a field-effect transistor, FET, e.g. a complementary metal-oxide semiconductor, CMOS, transistor. Such a transistor has three nodes: a controlling node, also referred to as controlling input, or gate, and two current conducting nodes, also referred to as drain and source respectively. A transistor acts as a controlled current source, wherein the current flowing through it is determined by the controlling input.

The controlling node of the feedback transistor is connected to the controlling node of the feedback sub-circuitry. The two current conducting nodes of the feedback sub-circuitry are the nodes of the transistor through which the controlled current flows.

When the reference voltage signal is (re-)set, a delay is introduced before the corresponding first and second intermediate voltages have settled. This delay depends on the signal path through the feedback sub-circuitry. By providing the feedback transistor, an efficient implementation of the feedback sub-circuitry is obtained that results in a short delay. In addition, the feedback transistor takes up limited chip area and requires no additional power consumption.

The feedback sub-circuitry may further comprise one or more resistors, one or more capacitors, one or more inductors to improve the behaviour of the feedback sub-circuitry. Optionally, the feedback sub-circuitry may also further comprise one or more additional transistors.

According to further example embodiments, the current source sub-circuitry comprises a current mirror configured to provide the bias current from a bias current source.

By providing a current mirror, the current source sub-circuitry provides a high output resistance. Therefore, the current provided by the current mirror is near to independent of the voltages over the current source sub-circuitry. As a result, the current source sub-circuitry closely approximates the behaviour of an ideal current source.

According to further example embodiments, the circuitry is further configured to receive a constant voltage as the reference voltage signal.

According to further example embodiments, the first amplifier comprises a first complementary transistor pair with current gains gₘ₁ and gₘ₂ provided between the first and second intermediate nodes jointly providing a current gain Gₘ of the first amplifier.

The complementary transistor pair comprises a first transistor and a second transistor that is complementary to the first transistor in the given technology. Controlling inputs of the first and second transistors are both connected to the input node. The first and second transistors are respectively connected to the first and second intermediate nodes. The first and second transistors are arranged in series, thus connected at one point, referred to as a series node. The output node is connected to the series node. As such, the output voltage can be pulled up to the first intermediate voltage by the first transistor and can be pulled down to the second intermediate voltage by the second transistor. The first and second transistors only conduct current simultaneously during switching of the first amplifier. By providing the complementary transistors, the first amplifier can be efficiently implemented.

The current gain Gₘ is the sum of the current gains gₘ₁ and gₘ₂. As such, the comparator circuitry provides a larger gain-bandwidth product than when using only a single transistor from input to output, without thereby lowering the delay. If the current gains gₘ₁ and gₘ₂ are the same, the total gain-bandwidth product of the comparator is doubled.

According to further example embodiments, the second amplifier comprises a second complementary transistor pair provided between the first and second intermediate nodes.

The second complementary transistor pair comprises a third transistor and a fourth transistor that is complementary to the third transistor in the given technology. Controlling inputs of the third and fourth transistors are both connected to the reference node, which is the input of the second amplifier. The third and fourth transistors are respectively connected to the first and second intermediate nodes. The third and fourth transistors are arranged in series, thus connected at one series point which is the output of the second amplifier. The feedback node is connected to this series point, thereby connecting the second amplifier to the controlling input of the feedback sub-circuitry.

Providing the second complementary transistor pair results in an efficient implementation of the second amplifier, introducing a limited delay and requiring limited chip area.

According to further example embodiments, the first and second amplifiers are identical.

With 'identical' is meant that the first and second amplifiers are the same electronic components i.e. having the same electronic properties, e.g. having the same amplifier gain. The first and second amplifiers may be identical in size.

By providing identical first and second amplifiers, the current within the comparator is equally distributed among the first and second amplifiers during switching of the first amplifier. This symmetry simplifies the working of the comparator circuitry, making it efficient. The setting of the local power supply by the second amplifier is seamlessly transferred to the first amplifier due to a one-to-one ratio.

According to further example embodiments, the circuitry further comprises an output buffer having as input the output node, as output a rail-to-rail output node, and as power supply nodes the first and second power supply nodes, and the circuitry is further configured to convert the output voltage signal to a rail-to-rail output voltage signal ranging between the voltages of the first and second power supply nodes.

The output buffer may also be referred to as an output inverter switch. When the first amplifier is not switching, the output node takes the value of either the first or of the second intermediate voltage signal. Thus, the range of the output voltage signal is limited to the constant voltage difference between the first and second intermediate voltage signals. The exact maximal and minimal values of the output voltage signal also vary depending on the momentaneous amplitudes of the first and second intermediate voltage signals. These amplitudes are determined by the reference voltage. By additionally providing the output buffer, the range of the output voltage signal is increased to the range of the voltage supply of the comparator. The output voltage signal thereby takes either the maximal or the minimal value provided by the voltage power supply. This can be useful for the further processing of the output voltage signal by a circuitry block that follows the comparator circuitry.

According to a second aspect, there is provided an analogue-to-digital converter, ADC, circuitry configured to convert an analogue data signal to a digital data signal, the ADC circuitry comprising one or more continuous-time comparator circuitries according to the first aspect. Such an ADC circuitry may provide one or more of the above-mentioned advantages.

The analogue signal is continuous both in time and in amplitude. The digital signal is a synchronous, quantised data signal.

According to further example embodiments, the ADC circuitry is further configured as a slope ADC; and, for a respective comparator circuitry:
- a constant voltage is applied as the reference voltage signal;
- the applied input voltage signal is the analogue data signal during a first sampling clock phase, and is a superposition of a sample of the analogue data signal at the end of the first sampling clock phase and a sawtooth signal during a second sampling clock phase.

The first sampling clock phase may be referred to as a 'tracking clock phase' and the second sampling clock phase may be referred to as a 'comparing clock phase'. A value of the continuous data signal is sampled at the end of the tracking clock phase and linearly incremented during the comparing clock phase. This is done by adding a sawtooth-shaped signal during the comparing clock phase. The output of the comparator circuitry toggles during the comparing clock phase when this combined input reaches the value of the reference voltage signal. In parallel, a counter may be provided which is started at the beginning of the comparing clock phase. Such a counter can then be sampled at the moment of toggling, thereby capturing the time it took before the combined input reached the reference voltage level. Because of the linear sawtooth pattern, this time can be converted to an amplitude of the sampled value of the continuous data signal.

### Brief Description of the Drawings

Fig. 1 illustrates a continuous-time comparator circuitry according to example embodiments;
Fig. 2 illustrates a continuous-time comparator circuitry wherein a current source sub-circuitry comprises a current mirror according to example embodiments;
Fig. 3 illustrates a continuous-time comparator circuitry wherein the first and second amplifiers are depicted on a transistor-level according to example embodiments;
Fig. 4 illustrates a continuous-time comparator circuitry comprising an output buffer according to example embodiments;
Fig. 5 illustrates a continuous-time comparator circuitry according to example embodiments;
Fig. 6 illustrates an ADC circuitry comprising a continuous-time comparator circuitry according to example embodiments; and
Fig. 7 illustrates voltage signals of an ADC circuitry according to example embodiments.

### Detailed Description of Embodiment(s)

The present disclosure relates to a continuous-time voltage comparator circuitry. By the term 'continuous-time' is meant that the behaviour of the comparator circuitry is asynchronous, i.e. not clocked and the circuitry provides a continuous output. Further, the continuous-time voltage comparator circuitry can take an input voltage signal that may have any value, i.e. is not quantised. The comparator circuitry compares the input voltage signal to a reference voltage signal and therefrom determines an output voltage signal. Since the input and output are voltage signals, the comparator circuitry can be referred to as a voltage-to-voltage comparator circuitry. The output voltage signal is a binary voltage signal, its value representing whether the input voltage signal is larger than or smaller than the reference voltage signal.

Such a comparator circuitry can be used as a building block in various electronic circuitries. Circuitries that may use a continuous-time voltage comparator circuitry comprise: threshold detector circuitries, window comparator circuitries, analogue-to-digital converter, ADC, circuitries, switching regulator circuitries, function generator circuitries, frequency-to-voltage converter circuitries and supply voltage supervisor circuitries.

In the present disclosure, the term 'node' may refer to an electrical connection point within the circuitry or to an electronic terminal of an electronic component, e.g. a transistor. Further, when denoting a voltage signal at a specified node, the term 'signal' may be omitted. For example, the input voltage signal may be referred to simply as the input voltage. Further, a voltage is always defined over two nodes. When referring to a voltage signal on a node this is implicitly meant relative to a reference voltage, i.e. a ground voltage or supply voltage.

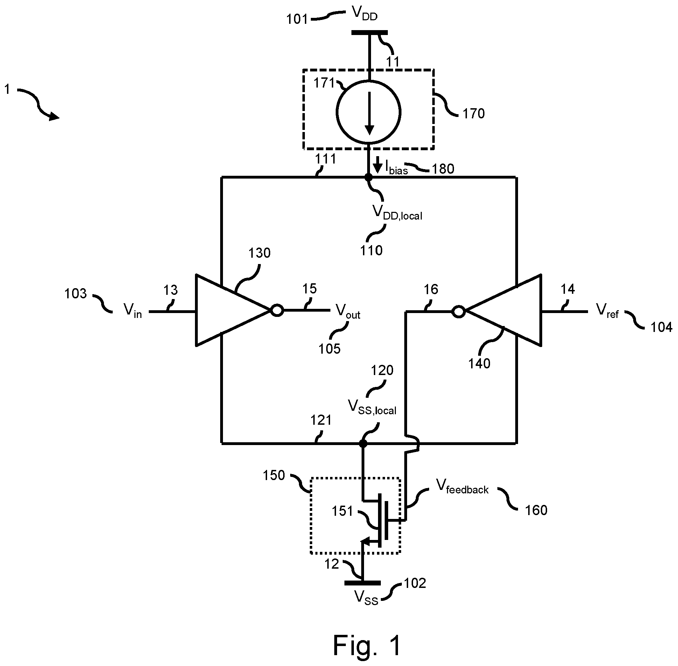

In Figure 1, a continuous-time voltage comparator circuitry 1 according to example embodiments is shown. The comparator circuitry 1 takes an input voltage, Vᵢₙ, 103 at an input node 13. The comparator circuitry 1 takes a reference voltage, V_{ref}, 104 at a reference node 14. The reference node 14 is a second input node of the comparator circuitry 1. Based on the voltages Vᵢₙ and V_{ref}, the comparator circuitry 1 generates an output voltage, Vₒᵤₜ, 105 at output node 15 triggered by a difference between the input voltage 103 and the reference voltage 104.

The comparator circuitry 1 is powered by power supply voltages Vss 102 and V_{DD} 101 to respective nodes 12 and 11. The voltage supply provides a voltage of V_{DD} minus Vss over power supply nodes 11, 12. V_{DD} is a higher voltage than Vss. The comparator circuitry 1 further comprises a current source sub-circuitry 170 configured to provide a constant bias current, I_{bias}, 180 between the first power supply node 11 and a first intermediate node 111. The current source sub-circuitry 170 comprises an independent current source 171. The fixed biasing provided by the sub-circuitry 170 enables the comparator 1 to maintain its accuracy even under significant PVT variations. For example, the circuitry 1 may exhibit a 20% current consumption variation when tested in 5 different PVT corners with voltage supply variations within ±5% and temperature variations between -40°C and 125°C.

Further, the comparator circuitry 1 comprises a first amplifier 130 taking the input voltage 103 as input and providing the output voltage 105 as output. The comparator circuitry 1 also comprises a second amplifier 140 taking the reference voltage 104 as input and providing a feedback voltage, V_{feedback}, 160 as output at a feedback node 16. Both amplifiers 130, 140 are powered by a voltage over the first intermediate node 111 and a second intermediate node 121. Therefore, a first intermediate voltage 110 at the first intermediate node 111 may also be referred to as a first local power supply voltage, 110, V_{DD,local}. Analogously, a second intermediate voltage 120 at the second intermediate node 121 may also be referred to as a second local power supply voltage, 120, V_{SS,local}. The intermediate nodes 111, 121 may respectively be referred to as first and second local power supply nodes 111, 121.

The comparator circuitry 1 further comprises a feedback sub-circuitry 150 configured to conduct the bias current 180 between the second power supply node 12 and the second intermediate node 121. The feedback sub-circuitry 150 has a controlling node 16 and two current conducting nodes 121, 12. The feedback sub-circuitry 150 is configured to draw current through the current conducting nodes 121, 12 based on the voltage 160 applied to the controlling node 16. As such, the feedback node 16 is fed back to the feedback sub-circuitry 150 such that voltages 110, 120 at the intermediate nodes 111, 121 follow the reference voltage 104. Thereby, a constant local power supply voltage V_{DD,local} - V_{SS,local} is provided over the amplifiers 130, 140 such that the triggering follows the reference voltage 104.

The first amplifier 130 is configured to toggle the output voltage 105 when the input voltage 103 crosses a value of the reference voltage 104. As such, the reference voltage 104 provides a threshold for the comparison. This is achieved via adjustment of the local power supply voltages V_{DD,local} and V_{SS,local} depending on the reference voltage 104. The first amplifier 130 provides the output voltage 105 with a voltage swing between the voltages at the intermediate nodes 111, 121. Because of the ability of the intermediate voltages 110, 120 to follow the reference voltage 104, the circuitry 1 remains accurate even when the reference voltage 104 deviates from half of the supply voltage, i.e. (V_{DD}-V_{SS})/2.

The first and second amplifiers 130, 140 may be identical, i.e. have the same electronic characteristics. For example, the amplifiers 130, 140 may comprise the same configuration of electronic components. The amplifiers 130, 140 may have the same size.

The feedback sub-circuitry 150 may be a single feedback transistor 151 provided between nodes 121 and 12. The technology of transistor 151 may, for example, be a metal-oxide field effect transistor, MOSFET, e.g. nMOS. The MOSFET transistor 151 has a gate terminal 16, a drain terminal 121 and a source terminal 12. The feedback node 16 is fed back to the gate 16 of the feedback transistor 151. In other words, the gate of transistor 151 is the controlling node of the feedback sub-circuitry 150. The drain 121 and source 12 of the transistor 151 are the current conducting nodes.

The comparator circuitry 1 has a high voltage-to-voltage gain and therefore provides a short delay at a low power consumption.

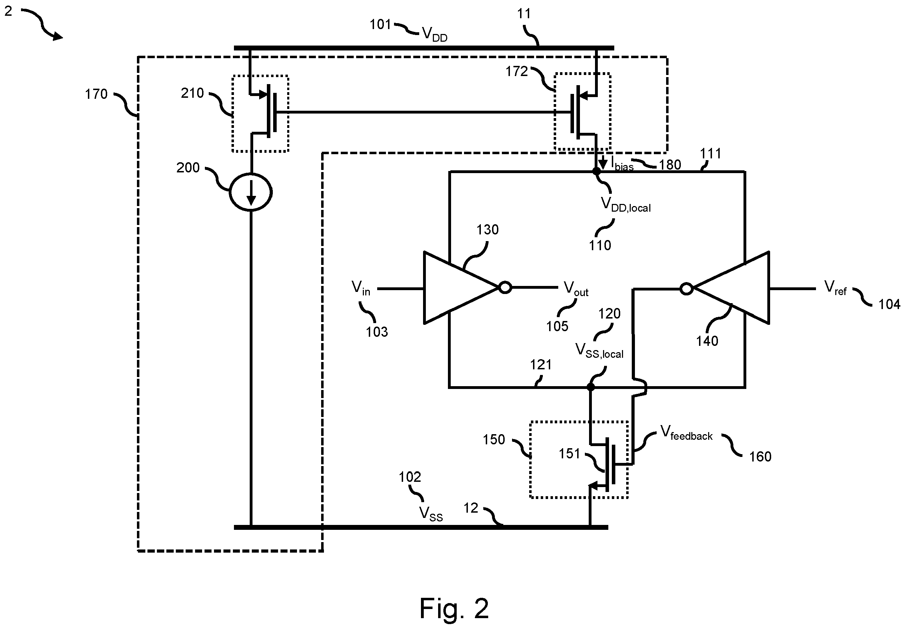

Figure 2 shows a comparator circuitry 2 according to example embodiments. The comparator circuitry 2 has a number of identical functional components as the comparator circuitry 1 of Figure 1. Identical components are indicated with the same reference numerals.

The comparator circuitry 2 has a current source sub-circuitry 170 is a current mirror configured to provide the bias current from a bias current source 200. The current mirror comprises an independent current source 200 in series with a first current source transistor 210. The transistor 210 may be a pMOS transistor. The series configuration of the source 200 and the transistor 210 is powered by the voltage power supply 101, 102. A gate of the transistor 210 is connected back-to-back to a gate of a second current source transistor 172. Transistor 172 is the same type of transistor as transistor 210. Transistor 172 is placed between the nodes 11, 111 to provide the bias current 180. The transistor 172 provides a stable current biasing to the comparator circuitry 2.

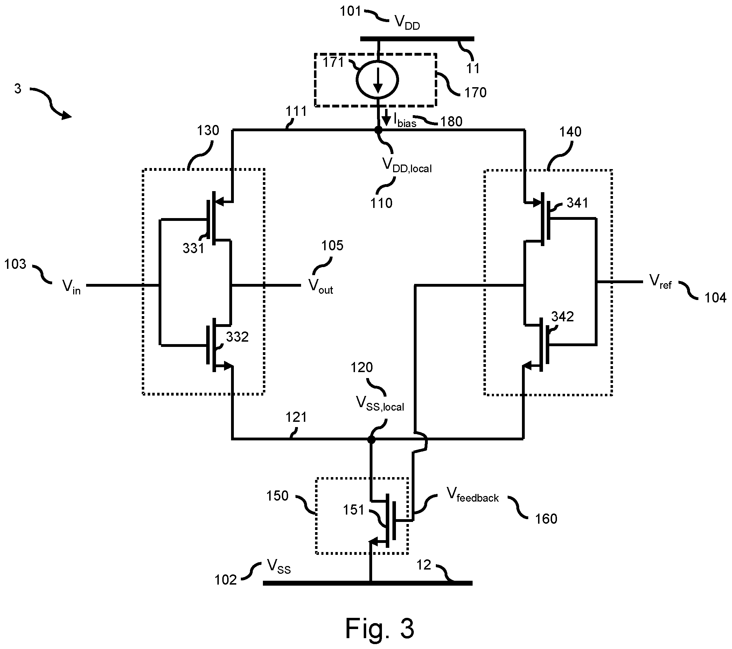

Figure 3 shows a comparator circuitry 3 according to example embodiments.

The comparator circuitry 3 has a number of identical functional components as the comparator circuitry 1 of Figure 1. Identical components are indicated with the same reference numerals.

The first amplifier 130 of comparator circuitry 3 comprises a first complementary transistor pair of first transistor 331 and second transistor 332. The transistors 331, 332 are of complementary technology. For example, transistor 331 may be a pMOS transistor and transistor 332 may be an nMOS transistor. The first transistor 331 has a current gain gₘ₁ and the second transistor 332 has a current gain gₘ₂. Jointly, the transistors 331, 332 provide the first amplifier with a total current gain Gₘ equal to gₘ₁ + gₘ₂ from the input voltage 103 to the output voltage 105. A gain-bandwidth product of comparator circuitry 1 can be expressed as Gₘ/C, wherein C is the total load capacitance at the output node 15.

The first transistor 331 is configured to pull the output voltage 105 up to intermediate voltage 110 when the input voltage 103 is smaller than the reference voltage 104. Neither of the transistors 331, 332 conduct any current as the output voltage 105 is pulled up. When the input voltage 103 is lower than the reference voltage 104, the voltage over the gate and the source is lower than a threshold voltage of the transistor 332.

The second transistor 332 is configured to pull the output voltage 105 down to intermediate voltage 120 when the input voltage 103 is larger than the reference voltage 104. Neither of the transistors 331, 332 conduct any current as the output voltage 105 is pulled down. When the input voltage 103 exceeds the reference voltage 104, the voltage over the gate and the source is lower than a threshold voltage of the transistor 331.

During operation of the comparator 1, the second amplifier 140 always draws current, whereas the first amplifier 130 only draws current when the input voltage 103 and the reference voltage 104 are close to equal. This is a consequence of the feedback mechanism from the reference voltage 104 to the intermediate voltages 110, 120. The first amplifier 130 only starts to conduct current when the threshold voltages of both transistors 331, 332 are reached. Thus, the first and second transistors 331, 332 do not conduct current when the input 103 is well above the reference voltage level 104 or well below the reference voltage level. The output voltage 105 then remains clipped against either the first or second intermediate voltage 110, 120. Only when the input voltage 103 is close to the level of the reference voltage 104 do the transistors 331, 332 conduct current. Then, the threshold voltages V_{T} of both transistors 331, 332 are reached. This can, for example, happen when the input voltage signal 103 has an alternating current, AC, component that passes through the reference voltage level, resulting in the toggling of output voltage 105. This can also happen when the input voltage signal 103 has a direct current, DC, component at the reference voltage level 104. Further, a varying reference voltage 104 that at some point matches the input voltage 103 can also induce the transistors 331, 332 to draw current.

The second amplifier 140 comprises a second complementary transistor pair of third transistor 341 and fourth transistor 342. The transistors 341, 342 are of complementary technology. For example, transistor 341 may be a pMOS transistor and transistor 342 may be an nMOS transistor. The third transistor 341 has a current gain gₘ₃ and the fourth transistor 342 has a current gain gₘ₄.

The transistors 341, 342 determine how much the reference voltage 104 can fluctuate around half of the supply voltage V_{DD} - Vss. In particular, the threshold voltages of the transistors 341, 342 determine the upper and lower limits for the reference voltage signal 104. During operation of the comparator circuitry 3, both transistors 341, 342 need to conduct current. In other words, the transistors 341, 342 need to be kept in strong inversion. Thus, a difference between the reference voltage 104 and the second intermediate voltage 120 can be as low as a threshold voltage V_{T,2} of transistor 342. Analogously, a difference between the first intermediate voltage 110 and the reference voltage 104 can be as low as a threshold voltage V_{T,1} of transistor 341.

If the first and second amplifiers 130, 140 are identical, transistor 331 is identical to transistor 341 and transistor 332 is identical to transistor 342. This means that the current gains gₘ₁, gₘ₃ are equal and the current gains gₘ₂, gₘ₄ are equal. The transistors 331, 341 may be equally sized and the transistors 332, 342 may be equally sized.

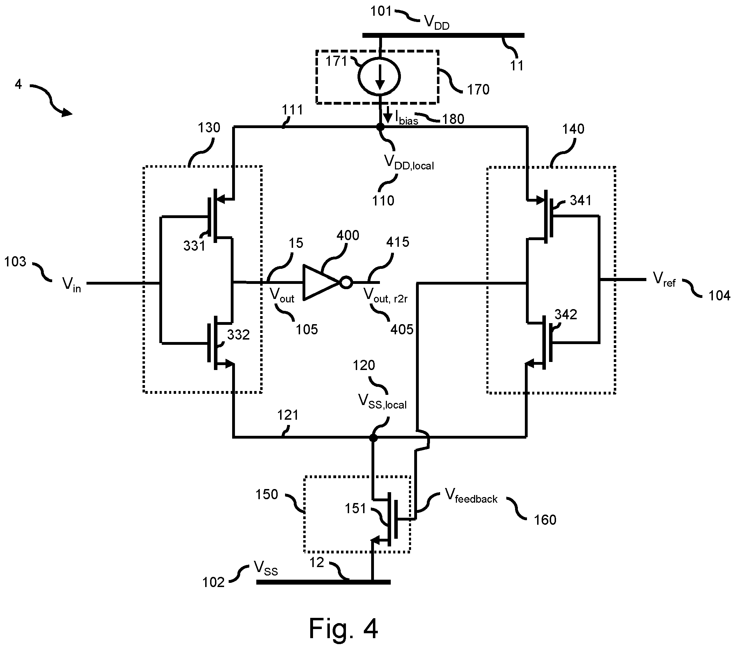

Figure 4 shows a comparator circuitry 4 according to example embodiments.

The comparator circuitry 4 is identical to the comparator circuitry 3 of Figure 3, with the exception of additional component 400. The identical components are indicated with the same reference numerals.

The comparator circuitry 4 comprises an output buffer 400 having as input the output node, as output a rail-to-rail output node 415, and as power supply nodes the first and second power supply nodes 11, 12. The output buffer 400 is configured to convert the output voltage signal 105 to a rail-to-rail output voltage signal 405 ranging between the voltages 101, 102 of the first and second power supply nodes 11, 12. As such, the rail-to-rail output voltage 405 can be easily used by a subsequent circuitry block.

Throughout the figures, transistors are depicted as metal-oxide semiconductor field-effect transistors, MOSFETs, implementing complementary metal oxide semiconductor, CMOS, technology. It is noted that the technology of the transistors can be any type, including, for example, bipolar junction transistors, BJTs. Further, it is noted that complementary solutions also fall under the comparator circuitry according to the first aspect. For example, this means the interchanging of nMOS vs. pMOS transistors in CMOS technology and npn vs. pnp transistors in BJT technology.

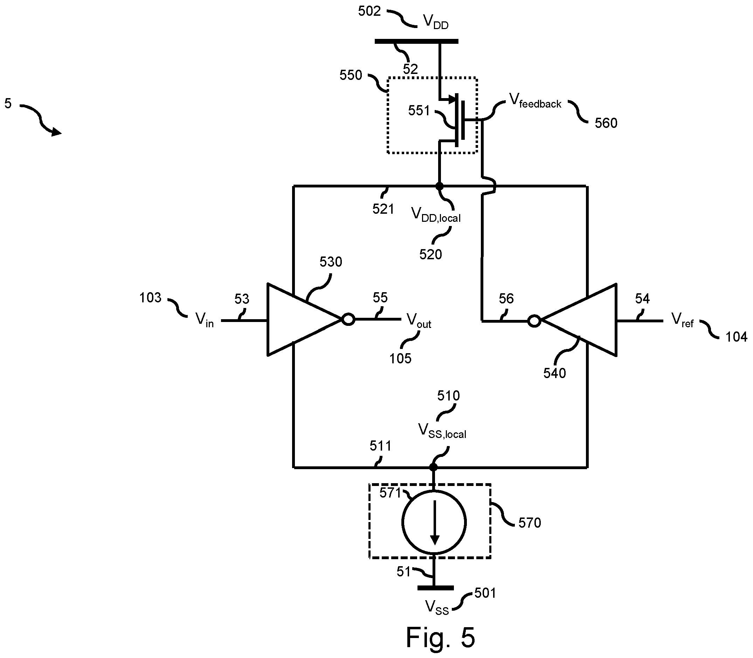

Figure 5 shows a comparator circuitry 5 according to example embodiments that is complementary to the comparator circuitry 1 of Figure 1.

Similar to comparator circuitry 1, comparator circuitry 5 is configured to generate the output voltage signal 105 at an output node 55 triggered by a difference between the input voltage signal 103 at an input node 53 and the reference voltage signal 104 at a reference node 54. The comparator circuitry 5 comprises the voltage power supply Vss, V_{DD} over a first voltage power supply node 51 and a second voltage power supply node 52. The comparator comprises current source sub-circuitry 570 configured to provide the bias current between the first power supply node 51 and a first intermediate node 511. A feedback sub-circuitry 570 is configured to conduct the bias current between the second power supply node 52 and a second intermediate node 521. The feedback sub-circuitry 570 comprises feedback transistor 551. Further, comparator circuitry 5 has first and second amplifiers 530, 540 similar to comparator circuitry 1.

Compared to the comparator circuitry 1, the current source sub-circuitry and the feedback sub-circuitry 570 comparator circuitry 5 are interchanged in the comparator circuitry 5. In addition, the amplifiers 530, 540 are complementary to the amplifiers 130, 140. The feedback transistor 551, a pMOS transistor, is complementary to the feedback transistor 151, an nMOS transistor.

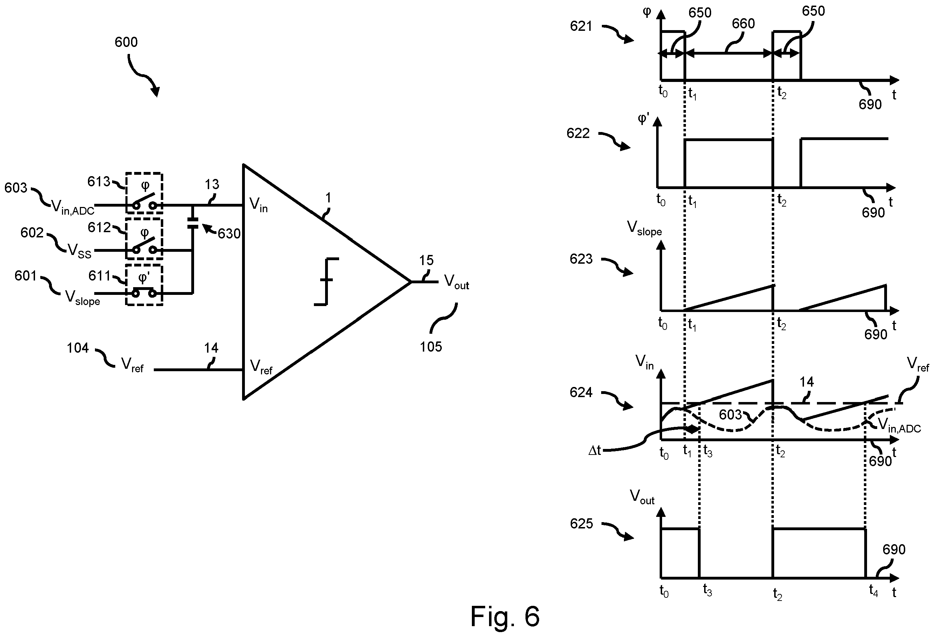

Figure 6 shows a slope ADC circuitry 600 comprising the continuous-time comparator circuitry 1 according to example embodiments.

The slope ADC circuitry 600 is configured to convert an analogue data signal, V_{in,ADC}, 603 to a digital data signal, Vₒᵤₜ, 105. The analogue signal 603 is continuous both in time and in amplitude. The digital signal 105 is a synchronous, quantised data signal. A constant voltage V_{ref} 104 is applied to the comparator circuitry 1 as the reference voltage signal. In addition, the input voltage signal 103 applied to the comparator circuitry 1 is the analogue data signal 603 during a tracking clock phase. The input voltage signal 103 applied to the comparator circuitry 1 is a superposition of a sample of the analogue data signal 603 at the end of the tracking clock phase φ and a sawtooth signal, Vₛₗₒₚₑ, 601 during a sampling clock phase φ'. The output voltage 105 of the comparator circuitry 1 is the digital data signal 105 provided by the ADC.

Subplot 621 shows a clock signal φ used to control switches 612, 613 of the ADC 600 as a function of time 690 during a time interval starting from time t₀. Subplot 622 shows a clock signal φ' used to control switch 611 of the ADC 600 as a function of time 690 starting from time t₀. Subplots 623, 624, 625 show voltages at respective nodes, Vₛₗₒₚₑ 601, Vᵢₙ, 13, and Vₒᵤₜ, 105 of the ADC 600 as a function of time 690 starting from time t₀. The time axes 690 of the subplots 621-625 are aligned to allow comparison of the different signals over time.

Subplot 621 shows the clock signal φ for controlling switches 612, 613 as a function of time 690. The clock signal φ has a tracking clock phase 650 lasting from time t₀ to time t₁. The tracking clock phase is followed by a sampling clock phase 660 lasting from time t₁ to time t₂. This is repeated over time such that the tracking clock phase and the sampling clock phase alternate each other. The clock signal has a high value, e.g. '1', during the tracking clock phase and has a low value, e.g. '0' during the sampling clock phase. As a result, during the tracking clock phase, the switches 612, 613 are closed. During the sampling clock phase, the switches 612, 613 are open.

Subplot 622 shows the clock signal 611 as a function of time 690. The clock signal 611 is the inverse of the clock signal 612, 613. As a result, the switch 611 is open during the tracking clock phase and closed during the sampling clock phase.

Subplot 623 shows the slope signal 601, which is a voltage that linearly increases during the sampling clock phase.

The application of the input signals 103 at input node 13 of the comparator 1 during the tracking and sampling clock phases is achieved by using the switches 611, 612, 613. A capacitor 630 is provided to allow temporary storage of the input voltage 603 during the sampling clock phase, while the slope signal 601 is superimposed to it.

Subplot 624 shows the input voltage of the comparator circuitry 1 on the node 13 over the course of the clock phases, indicated with a solid line. An analogue data signal, V_{in,ADC}, 603, indicated with a curving striped line, fluctuates over time and is provided to the ADC. During the tracking clock phase, the data signal 603 is provided on the input node 13 of the comparator circuitry 1. During the tracking clock phase, the capacitor 630 is being loaded as it is provided between the data signal 603 and a lower voltage supply node, Vss, 602, e.g. ground or zero Volt. This is done by closing switches 612, 613 while keeping switch 611 open. At ti, the sampling clock phase starts and switches 612, 613 open and switch 611 closes. Because of capacitor 630, the data signal 603 remains temporarily captured at the node 13. The closed switch 611 allows the slope signal 601 to become superimposed onto the temporarily stored data signal 603 at the input node 13 of the comparator 1. As a result, the input signal 103 of comparator 1 is gradually increased until it reaches the value of the reference voltage 104 at time ts. The reference voltage 104 is indicated by a striped horizontal line. The time difference Δt, equal to t₃ minus t₁, is a measure for the amplitude of data signal 603. After the sampling clock phase, the tracking phase is initiated again by closing switches 612, 613 and opening switch 611. Thereby, the voltage at node 13 and the comparator output 105 readjust to the data signal 603.

Subplot 625 shows the resulting output voltage, Vₒᵤₜ, 105. Subplot 625 shows that every time V_{ref} is reached, the comparator 1 toggles the output voltage, Vₒᵤₜ, 105.

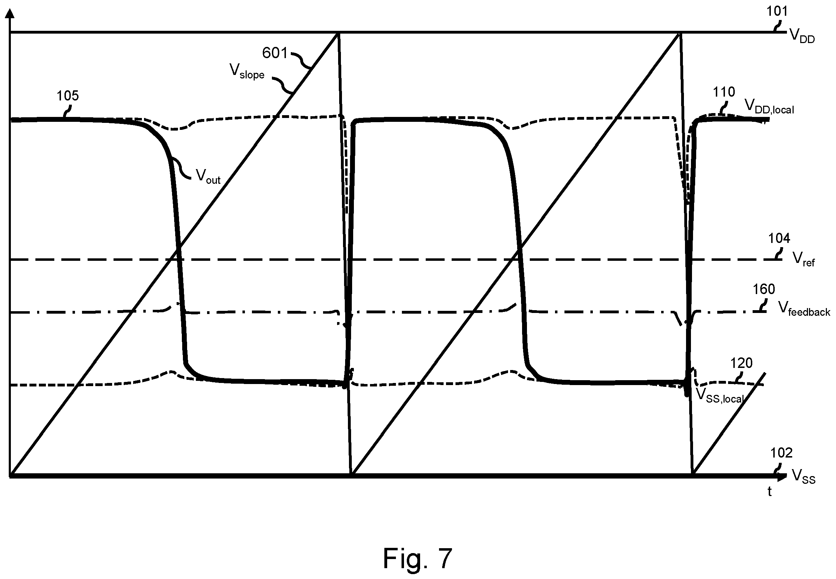

Figure 7 shows the different voltage signals over time within the comparator circuitry 1 when input signals are applied to it according to the ADC circuitry 600 of Figure 6 according to example embodiments.

Figure 7 is a voltage-time plot showing the ADC output voltage 105, indicated with a solid line, when the ADC input voltage 603 is kept to 0 V. The power supply voltages V_{DD} and Vss are indicated with solid lines 101, 102. V_{DD} may, for example, be 0.8 Volt, V, and Vss may be 0 V. The reference voltage 104 is indicated by a striped constant line halfway the power supply, e.g. at 0.4 V. As a result of the reference voltage 104 applied at the second amplifier 140 of the comparator 1, the first and second intermediate voltages, V_{DD,local}, 110, V_{SS,local}, 120 are constant. The local supply voltages V_{DD,local}, V_{SS,local} are at equal distances from the reference voltage 104, e.g. 0.63 V and 0.17 V respectively. The local supply voltages V_{DD,local}, V_{SS,local} may show some limited fluctuations, in particular as a result of the toggling of the first amplifier 130. This occurs due to the first amplifier 130 drawing current during the toggling. The feedback voltage 160 is also shown in the plot, showing similar fluctuations as a result of the switching of the first amplifier 130. Further, Figure 7 shows a slope signal 601 to superimpose on an ADC input voltage 603 during the sampling phase.

As used in this application, the term "circuitry" may refer to one or more or all of the following: (a) hardware-only circuit implementations (such as implementations in only analog and/or digital circuitry) and (b) combinations of hardware circuits and software, such as (as applicable): (i) a combination of analog and/or digital hardware circuit(s) with software/firmware and (ii) any portions of hardware processor(s) with software (including digital signal processor(s)), software, and memory(ies) that work together to cause an apparatus, such as a mobile phone or server, to perform various functions) and (c) hardware circuit(s) and or processor(s), such as a microprocessor(s) or a portion of a microprocessor(s), that requires software (e.g., firmware) for operation, but the software may not be present when it is not needed for operation. This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein. In other words, it is contemplated to cover any and all modifications, variations or equivalents that fall within the scope of the basic underlying principles and whose essential attributes are claimed in this patent application. It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A continuous-time comparator circuitry (1, 5) for generating an output voltage signal (105) at an output node (15, 55) triggered by a difference between an input voltage signal (103) at an input node (13, 53) and a reference voltage signal (104) at a reference node (14, 54), the comparator circuitry comprising:
- a first voltage power supply node (11, 51) and a second voltage power supply node (12, 52);
- a current source sub-circuitry (170, 570) configured to provide a bias current (180) between the first power supply node and a first intermediate node (111, 511);
- a feedback sub-circuitry (150, 550) configured to conduct the bias current between the second power supply node and a second intermediate node (121, 521);
- a first amplifier (130, 530) having as input the input node, as output the output node, and as voltage power supply the first and second intermediate nodes thereby providing the output voltage signal with a voltage swing between the voltages at the first and second intermediate nodes; and
- a second amplifier (140, 540) having as input the reference node, as output a feedback node (16, 56), and as voltage power supply the first and second intermediate nodes;
wherein the feedback node is fed back to the feedback sub-circuitry such that voltages at the first and second intermediate node follow the reference voltage signal, thereby providing a constant power supply voltage over the first and second amplifiers such that the triggering follows the reference voltage signal.

2. The circuitry (1) according to claim 1, wherein the feedback sub-circuitry (150) comprises a feedback transistor (151) provided between the second power supply node (102) and the second intermediate node (121); and wherein the feedback node (16) is fed back to a gate of the feedback transistor (151).

3. The circuitry (1) according to any one of the preceding claims, wherein the current source sub-circuitry (170) comprises a current mirror (172, 210) configured to provide the bias current from a bias current source (200).

4. The circuitry (1) according to any one of the preceding claims, further configured to receive a constant voltage as the reference voltage signal (104).

5. The circuitry (1) according to any one of the preceding claims, wherein the first amplifier (130) comprises a first complementary transistor pair (331, 332) with current gains gₘ₁ and gₘ₂ provided between the first and second intermediate nodes jointly providing a current gain Gₘ of the first amplifier.

6. The circuitry (1) according to any one of the preceding claims, wherein the second amplifier (140) comprises a second complementary transistor pair (341, 342) provided between the first and second intermediate nodes.

7. The circuitry (1) according to any one of the preceding claims, wherein the first and second amplifiers are identical.

8. The circuitry (1) according to any one of the preceding claims, further comprising an output buffer (400) having as input the output node, as output a rail-to-rail output node (415), and as power supply nodes the first and second power supply nodes (11, 12), and further configured to convert the output voltage signal (105) to a rail-to-rail output voltage signal (405) ranging between the voltages (101, 102) of the first and second power supply nodes (11, 12).

9. An analogue-to-digital converter, ADC, circuitry (600) configured to convert an analogue data signal to a digital data signal, the ADC circuitry comprising one or more continuous-time comparator circuitries (1) according to any one of the preceding claims.

10. The ADC circuitry (600) according to claim 9, wherein the ADC circuitry is further configured as a slope ADC; and wherein, for a respective comparator circuitry:
- a constant voltage is applied as the reference voltage signal (104);
- the applied input voltage signal (103) is the analogue data signal during a first sampling clock phase, and is a superposition of a sample of the analogue data signal at the end of the first sampling clock phase and a sawtooth signal during a second sampling clock phase.
